Europäisches Patentamt

European Patent Office

Office européen des brevets

(11) Veröffentlichungsnummer: **0 253 299**
**A1**

# (12) EUROPÄISCHE PATENTANMELDUNG

(21) Anmeldenummer: 87109880.2

(22) Anmeldetag: 08.07.87

(51) Int. Cl.⁴: **H01L 23/48 , H01L 23/52**

(30) Priorität: 09.07.86 DE 3623137

(43) Veröffentlichungstag der Anmeldung:
20.01.88 Patentblatt 88/03

(84) Benannte Vertragsstaaten:
**BE DE FR GB**

(71) Anmelder: **Siemens Aktiengesellschaft Berlin
und München
Wittelsbacherplatz 2
D-8000 München 2(DE)**

(72) Erfinder: **Eggers, Harald, Dipl.-Ing.
Erich-Kästner-Strasse 19
D-8000 München 40(DE)**
Erfinder: **Asam, Wilhelm, Dipl.-Phys.
Sommerstrasse 22
D-8000 München 83(DE)**
Erfinder: **Preis, Walter, Dipl.-Ing. (FH)
Fasanenweg 20
D-8011 Pliening(DE)**
Erfinder: **Schloss, Dietrich, Ing. (FH)
Klagenfurter Strasse 12
D-8000 München 80(DE)**
Erfinder: **Eckstein, Elke
Sommerstr. 22
D-8000 Muenchen 83(DE)**

(54) **Metallisierung für integrierte Schaltungsanordnungen.**

(57) Die vorgeschlagene, für Leitbahnsysteme von integrierten Schaltungsanordnungen genutzte Sandwichmetallisierung mit einer Schichtenfolge aus Platinsilizid (2) und mehreren durch Alumninium-oder Aluminium-Silizium-Schichten mit und ohne Legierungszusätzen (4, 6) voneinander getrennten Titan-, Titanwolfram-oder Titannitridschichten (3, 5, 7) weist gegenüber bekannten Metallisierungen Vorteile hinsichtlich Strombelastbarkeit, Hillockbildung und Leitbahndefekten auf und bietet Möglichkeiten der Selektivätzung, geneigter Ätzflanken und erhebliche Platzeinsparungen bei Mehrlagenmetallisierungen.

## Metallisierung für integrierte Schaltungsanordnungen

Die Erfindung betrifft eine Metallisierung für integrierte Schaltungsanordnungen nach dem Oberbegriff des Patentanspruchs 1.

Die üblicherweise als Leitbahnsysteme für integrierte Schaltungsanordnungen genutzten Metallisierungen bestehen vorwiegend aus dem Aluminium-Silizium-System, das neben Aluminium oder Aluminium-Silizium noch Legierungszusätze enthalten kann, z.B. Titan, Kupfer oder Metalle mit ähnlichen Eigenschaften. Dieses Aluminium-Silizium-System ist jedoch nur begrenzt strombelastungsfähig und kaum noch zum Transport höherer als bereits üblicher Stromdichten extrapolierbar. Höhere Stromdichten sind allerdings erforderlich zur weiteren Verkleinerung integrierter Schaltkreise.

Weiterhin neigt das Aluminium-Silizium-System, speziell das Aluminium, zur Bildung von Hillocks bei den vorgesehenen Temperaturzyklen; außerdem wird gelegentlich Korrosion beobachtet, vor allem bei Anwendung von Trockenätzverfahren zur Strukturierung der Leitbahnen. Begrenzungen sowohl in der Designflexibilität als auch bei der Erhöhung der Integrationsdichte integrierter Schaltungen ergeben sich aus der Tatsache, daß Aluminium-Silizium-Schichten nicht selektiv gegen dotiertes und undotiertes Silizium trockengeätzt werden können, d.h., daß in jedem Fall eine ausreichende Überlappung der Aluminium-Silizium Metallisierung über das als Verbindung zum Silizium dienende Kontaktfenster erforderlich ist.

Der Erfindung liegt die Aufgabe zugrunde, eine Metallisierung für integrierte Schaltungsanordnungen anzugeben, die gegenüber einer Metallisierung aus Aluminium-Silizium mit und ohne Legierungszusätzen Vorteile bietet.

Diese Aufgabe wird bei einer Metallisierung der eingangs genannten Art erfindungsgemäß durch die Merkmale des kennzeichnenden Teils des Patentanspruchs 1 gelöst.

Weitere Ausgestaltungen des Erfindungsgedankens sind in unter Ansprüchen gekennzeichnet.

Die Erfindung wird im folgenden anhand eines in der einzigen Figur der Zeichnung dargestellten Ausführungsbeispiels näher erläutert.

In einer Siliziumschicht Si befindet sich ein napfförmiges Kontaktfenster 1, das sich durch eine gegenüber der Siliziumschicht Si wesentlich höhere Dotierung auszeichnet. Die erfindungsgemäße Metallisierung ist gekennzeichnet durch eine Sandwich-Schichtenfolge aus Platinsilizid und mehrere durch Aluminium-oder Aluminium-Silizium-Schichten mit und ohne Legierungszusätzen voneinander getrennte Titan-, Titanwolfram-oder Titannitridschichten. Dabei befindet sich die Platinsilizidschicht 2 nur auf dem Kontaktfenster 1 und ist ausgehend von der Oberfläche der Siliziumschicht Si und der Platinsilizidschicht 2 überdeckt von drei Titan-, Titanwolfram-oder Titannitridschichten 3, 5 und 7, die durch die Alu-minium - oder Aluminium-Silizium-Schichten mit und ohne Legierungszusätze 4 und 6 voneinander getrennt sind. Erfindungsgemäß werden mindestens zwei Titan-, Titanwolfram-oder Titannitridschichten und eine entsprechende Zahl Trennschichten aus den erwähnten Aluminiumverbindungen aufgebracht.

Die erfindungsgemäße Sandwich-Schichtenfolge kann durch ein geeignetes Sputterverfahren in einem Arbeitsschritt aufgetragen werden. Auch die Strukturierung ist durch entsprechend gewählte Trockenätzverfahren in einem Arbeitsschritt möglich.

Für die Schichtdicken der Sandwichmetallisierung gelten folgende Werte: Für die Platinsilizidschicht 2 ist aus Gründen der Prozeßzeiten und parasitärer Effekte in der bereits strukturierten Siliziumschicht Si eine Dicke von 60 bis 70 nm vorgesehen. Die unteren Titan-, Titanwolfram - oder Titannitridschichten, z.B. 3 und 5, weisen eine Dicke von 40 bis 600 nm, vorzugsweise jedoch etwa 100 nm auf. Die Aluminium-oder Aluminium-Silizium-Schichten mit und ohne Legierungszusätzen 4 bzw. 6 liegen mit ihrer Dicke im Bereich zwischen 100 bis 1000 nm, vorzugsweise jedoch bei 400 nm, und für die obere Titan-, Titanwolfram-oder Titannitridschicht 7 beträgt die Dicke 60 bis 600 nm, aber eher weniger als die darunterliegenden Schichten aus den angegebenen Titanverbindungen. Dabei ist es vorteilhaft, die Schichtdicke von der oberen Aluminium-oder Aluminium-Silizium-Schicht 6 mit und ohne Legierungszusätzen zu den unteren Schichten 5 bis 3 hin abnehmen zu lassen.

Zu den Vorteilen einer derartigen erfindungsgemäßen Metallisierung zählen neben der höheren Strombelastbarkeit um beispielsweise den Faktor 10 eine geringere oder gar keine Hillockbildung und eine geringe Neigung zur Ausbildung von Leitbahndefekten aufgrund parasitärer Effekte, z.B. der Elektromigration, der Korrosion und der Degradierung der Temperaturkoeffizienten. Weiterhin bietet die erfindungsgemäße Sandwichmetallisierung die Möglichkeit der selektiven Trockenätzung der auf der Siliziumschicht Si aufgetragenen Sandwichmetallisierung mit den Schichten 3 bis 7 gegenüber der Kontaktmetallisierung des Platinsilizids 2, da die unterste Titan-, Titanwolframram - oder Titannitridschicht 3 in einem Ätzmedium strukturiert werden kann, das Platinsilizid gar nicht oder nur geringfügig angreift.

Zudem bietet die erfindungsgemäße Sandwichmetallisierung die Möglichkeit geneigter Ätzflanken, weil die oberste Titan-, Titanwolfram - oder Titannitridschicht 7 isotrop geätzt werden kann, was beim anschließenden Aluminium-Silizium-Ätzprozess zur Ausbildung geneigter Ätzflanken führt. Die Ätzflanken sind nach einem derartigen Ätzprozess nicht durchgehend gleichmäßig geneigt, sondern zeigen vielmehr eine leichte Stufung, deren Einhüllende geneigt ist. Daraus ergibt sich vor allem beim Auftragen weiterer Materialien, z.B. einem anschließendem Oxydauftrag, eine bessere Einebnung der Oberfläche und die Vermeidung von Einschnürungen und Überhängen des weiteren zusätzlich aufgetragenen Materials.

Die erfindungsgemäße Sandwichmetallisierung, insbesondere aus den Schichten 3 bis 7, bietet die Möglichkeit zur Ausbildung sogenannter "non nested viaholes" bei der Mehrlagenmetallisierung von integrierten Schaltungsanordnungen. Dabei kann aufgrund der Ätzselektivität zwischen Titan-, Titanwolfram oder Titannitrid und Aluminium oder Aluminium-Silizium mit und ohne Legierungszusätzen auf die Umrandung von "viaholes" in oberen Metallisierungsebenen von integrierten Schaltungsanordnungen verzichtet werden. Aus dieser Tatsache ergeben sich erhebliche Platzeinsparungen für die Realisierung von integrierten Schaltungsanordnungen mit Mehrlagenmetallisierung.

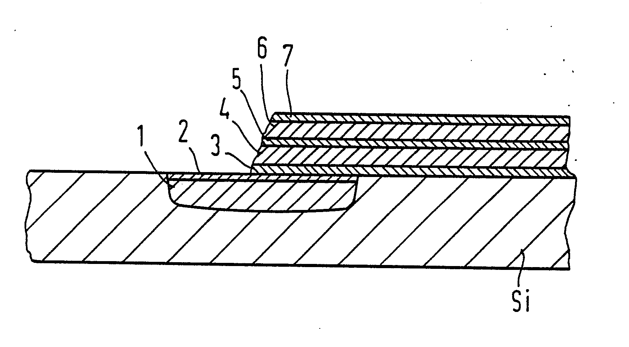

Die für die Leitbahnmetallisierungen benutzten Schichten 3 bis 7 der erfindungsgemäßen Metallisierung können natürlich nicht nur auf einer Siliziumschicht Si gem. Fig. 1 aufgetragen werden, sondern auch auf anderen, bei der Herstellung von integrierten Schaltungsanordnungen benutzten Oberflächen, z.B. Siliziumoxyd oder Siliziumnitrid. Durch die untere Titan-, Titanwolfram - oder Titannitridschicht 3 der erfindungsgemäßen Metallisierung wird in jedem Fall die Haftung der Leitbahn auf der jeweiligen Unterlage verbessert. Gleichzeitig dient die untere Schicht 3 als Diffussionsbarriere zwischen der Aluminium-oder Aluminium-Silizium-Schicht mit und ohne Legierungszusätzen 4 und der Platinsilizidschicht 2. Diese an sich bekannte Kontaktmetallisierung zeichnet sich durch niederohmige und stabile Kontaktbildung aus. Gleichzeitig führt diese Kontaktmetallisierung zur Ausbildung von Schottky-Kontakten bei geeignetem Untergrund und geeigneten Prozeß.

Andererseits dient die obere Titan-, Titanwolfram - oder Titannitridschicht 7 als Ätzbarriere bei der Ätzung der Aluminium-Silizium-Schichten mit und ohne Legierungszusätzen, d.h. implizit, daß bei der Fotostrukturierung der erfindungsgemäßen Sandwichmetallisierung geringere Lackdicken möglich werden und die Strukturfeinheit erhöht werden kann. Gleichzeitig dient die Schicht 7 als Antireflexschicht beim Fotolithographieprozeß.

## Ansprüche

1. Metallisierung für integrierte Schaltungsanordnungen unter Verwendung von Aluminium oder Aluminium-Silizium mit und ohne Legierungszusätzen, **gekennzeichnet** durch eine Sandwich-Schichtenfolge aus Platinsilizid (2) und mehreren durch Aluminium-oder Aluminium-Silizium-Schichten mit und ohne Legierungszusätzen (4,6) voneinander getrennte Titan-, Titanwolfram-oder Titannitridschichten (3, 5, 7).

2. Metallisierung nach Anspruch 1, **dadurch gekennzeichnet**, daß die Platin-Silizidschicht (2) nur auf Halbleiter-Kontaktflächen (1) aufgetragen wird.

3. Metallisierung nach Anspruch 1 und 2, **dadurch gekennzeichnet**, daß die Schichtdicke von der oberen Aluminium - oder Aluminium-Silizium-Schicht mit und ohne Legierungszusätzen (6) zu den unteren Schichten (5 bis 3) hin abnimmt.

4. Metallisierung nach Anspruch 1 bis 3, **dadurch gekennzeichnet**, daß die Schichtdicken für die Platin-Silizidschicht (2) 60 bis 70 nm, für die unteren Titan-, Titanwolfram-oder Titannitridschichten (3, 5) 40 bis 600 nm, vorzugsweise 100 nm, für die Aluminium-oder Aluminium-Silizium-Schichten mit und ohne Legierungszusätzen (4, 6) 100 bis 1000 nm, vorzugsweise etwa 400 nm und für die obere Titan-, Titanwolfram-oder Titannitridschicht (7) 60 bis 600 nm betragen.

5. Metallisierung nach Anspruch 1 bis 4, **dadurch gekennzeichnet**, daß die Metallisierung in einem Arbeitsprozeß durch Sputtern aufgetragen wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4 566 026 (HONEYWELL) <br> * Figur; Patentansprüche 1,5,6,21 * | 1 | H 01 L 23/48 <br> H 01 L 23/52 |
| A | | 4 | |
| | --- | | |
| Y | EP-A-0 002 731 (IBM) <br> * Figur 1; Patentansprüche 1,2,6,11 * | 1 | |
| A | | 2,4,5 | |
| | --- | | |
| A | IBM TECHNICAL DISCLOSURE BULLETIN, Band 13, Nr. 2, Juli 1970, Seiten 511-512, New York, US; W.E. MUTTER et al.: "Ag metallurgy system for integrated circuit devices" | 1,2 | RECHERCHIERTE SACHGEBIETE (Int. Cl.4) <br><br> H 01 L |
| | --- | | |
| A | SOLID-STATE ELECTRONICS, Band 12, Nr. 2, Februar 1969, Seiten 107-109, Pergamon Press, Oxford, GB; S.M. SZE et al.: "Metal-semiconductor IMPATT diode" <br> * Figur 1 * | 1,2,4 | |
| | ---     -/- | | |

Der vorliegende Recherchenbericht wurde für alle Patentansprüche erstellt.

| Recherchenort | Abschlußdatum der Recherche | Prüfer |
|---|---|---|
| DEN HAAG | 10-09-1987 | DE RAEVE R.A.L. |

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| A | JOURNAL OF APPLIED PHYSICS, Band 53, Nr. 12, Dezember 1982, Seiten 8827-8834, American Institute of Physics, New York, US; H. SCHABER et al.: "Laser annealing study of the grain size effect in polycrystalline silicon Schottky diodes" * Figur 1 * | 1,2 | |
| A | THIN SOLID FILMS, Band 104, Nr. 1/2, Juni 1983, Seiten 89-99, Elsevier Sequoia, Lausanne, CH; R.J. SCHUTZ: "TiN as a diffusion barrier between $CoSi_2$ or PtSi and aluminum" | 1,2,4 | |
| A | THIN SOLID FILMS, Band 96, Nr. 4, Oktober 1982, Seiten 327-345, Elsevier Sequoia, Lausanne, CH; C.Y. TING et al.: "The use of titanium-based contact barrier layers in silicon technology" | 1,4 | RECHERCHIERTE SACHGEBIETE (Int. Cl.4) |
| A | THIN SOLID FILMS, Band 88, Nr. 1, Februar 1982, Seiten 9-23, Elsevier Sequoia, Lausanne, CH; C. CANALI et al.: "Interdiffusion and compound formation in the c-Si/PtSi/(Ti-W)/Al System" | 1,2,4, 5 | |

Der vorliegende Recherchenbericht wurde für alle Patentansprüche erstellt.

| Recherchenort | Abschlußdatum der Recherche | Prüfer |
|---|---|---|
| DEN HAAG | 10-09-1987 | DE RAEVE R.A.L. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82